# FASCICULE DE BREVET EUROPEEN

(11) **EP 4 345 575 B1**
(45) Date de publication et mention de la délivrance du brevet: **04.09.2024**
(21) Numéro de dépôt: 22306437.9
(22) Date de dépôt: 28.09.2022
(51) Int. Cl.: G06F 1/20, H05K 7/20

(54) **PROCÉDÉ DE FABRICATION D'UN DISSIPATEUR THERMIQUE**
VERFAHREN ZUR HERSTELLUNG EINES KÜHLKÖRPERS
METHOD FOR MANUFACTURING HEAT SINK

(43) Date de publication de la demande: 03.04.2024
(73) Titulaire: BULL SAS, 78340 Les Clayes-Sous-Bois (FR); Le Commissariat à l'énergie atomique et aux énergies alternatives, 75015 Paris (FR)
(72) Inventeur: LAMY, Pierre, 75014 PARIS (FR); DEMANGE, Fabien, 78260 ACHÈRES (FR)
(74) Mandataire: Argyma

(56) Documents cités:
- US-A1- 2018 320 993
- US-A1- 2021 176 896

## Description

### [Domaine technique]

La présente invention se rapporte au domaine du refroidissement des processeurs informatiques et concerne plus particulièrement un dissipateur thermique pour carte électronique de supercalculateur.

### [Etat de la technique antérieure]

Les lames de calcul pour serveur, notamment pour supercalculateur, comportent généralement des cartes électroniques, notamment des processeurs, qui dégagent de la chaleur et doivent donc être refroidies. Initialement, ces cartes électroniques étaient refroidies par de l'air. Toutefois, dans le cas de serveurs montables sur bâti, la circulation d'air n'est pas suffisante pour refroidir les cartes électroniques. Pour résoudre ce problème, des systèmes de refroidissement fluidiques ont été développés.

Parmi les solutions connues de refroidissement de cartes électroniques, la société IBM^{®} a mis au point un système de refroidissement mixte de cartes électroniques double processeur pour supercalculateur. Un tel système comporte des tuyaux en cuivre contenant un liquide caloporteur formant une boucle liquide. Toutefois, la rigidité des tuyaux en cuivre ne permet pas le démontage rapide d'un unique processeur. En outre, la boucle liquide assure le refroidissement des processeurs uniquement. Le reste de la puissance dissipée est refroidie par convection dans l'air, ce qui n'est pas optimal pour l'efficacité énergétique (PUE, acronyme désignant en anglais « Power Usage Effectiveness ») du supercalculateur.

D'autres fabricants de cartes électroniques proposent des systèmes de refroidissement liquides dédiés uniquement aux processeurs. Ces derniers intègrent un dissipateur thermique, une pompe intégrée et un échangeur pour extraire les calories. Bien entendu, de tels dispositifs ne sont pas compatibles avec des systèmes de plus grande échelle comme les supercalculateurs pour des raisons d'encombrement.

La demanderesse a mis au point, par ailleurs, un système de refroidissement mixte dans lequel les cartes électroniques sont refroidies par l'intermédiaire d'une plaque froide en aluminium dans laquelle circule un liquide caloporteur, la plaque froide étant interfacée avec tous les composants électroniques bas et moyens à refroidir, c'est-à-dire l'ensemble des composants d'une carte électronique à l'exclusion des composants électroniques hauts (typiquement les processeurs et les barrettes mémoires). Les processeurs sont les composants les plus contraignants à refroidir (car ils doivent rester accessibles) et aussi les plus dissipatifs. Ils ne peuvent pas être interfacés avec la plaque froide directement. Afin d'assurer le contact thermique avec les processeurs, chacun d'eux est interfacé avec un dissipateur thermique intermédiaire à caloducs. Il s'agit d'un dissipateur thermique diphasique à changement de phase (généralement désigné en anglais par les termes « Heat Spreader CPU »), qui conduit la chaleur des processeurs vers la plaque froide. La partie des caloducs en contact avec la dalle en cuivre qui interface le processeur constitue l'évaporateur, tandis que celle en contact avec la plaque froide constitue le condenseur. Cette solution est décrite de manière plus détaillée dans les demandes de brevet européen EP 2770809 et EP 2770810 appartenant à la demanderesse.

Cette solution de refroidissement des processeurs à l'aide de caloducs présente également des inconvénients, et en particulier :
- des limites thermiques spécifiques aux caloducs : l'écoulement à l'intérieur d'un caloduc est diphasique et est régi par cinq limites en termes d'écoulement, de viscosité, d'ébullition, d'entraînement, de capillarité, qui dépendent des dimensions des caloducs et de la puissance à évacuer.
- des limites mécaniques : l'augmentation du nombre de caloducs entraîne une augmentation de la rigidité de l'ensemble. Or, afin de compenser les écarts de tolérances, il est indispensable que le dissipateur se déforme suffisamment.
- un nombre élevé d'interfaces thermiques amovibles : des contacts thermiques doivent être assurés entre la plaque froide et le dissipateur thermique d'une part, et entre le dissipateur thermique et le processeur. Ces contacts thermiques sont, dans la solution actuelle mise en place par la demanderesse, garantis par l'utilisation de graisse conductrice, présentant l'inconvénient de générer un gradient de température élevé.
- la complexité et le coût de la solution globale : les surfaces d'échanges solide/fluide sont actuellement au niveau de la plaque froide. La complexité de celle-ci au niveau des dissipateurs thermiques augmente considérablement les usinages dans la plaque froide et ainsi le coût de fabrication.

Pour résoudre les défauts et inconvénients susmentionnés, la demanderesse a mis au point un système de refroidissement pour une carte électronique qui est entièrement liquide, comprenant une plaque froide alimentée en fluide caloporteur via un chemin d'eau interne à la plaque froide, et une pluralité de dissipateurs thermiques reliés en liaisons souples avec le chemin d'eau interne à la plaque froide. Ces liaisons souples forment un réseau flexible couplé au réseau de canaux rigides de la plaque froide alimenté en fluide caloporteur (typiquement de l'eau glycolée), permettant ainsi l'alimentation en fluide caloporteur des dissipateurs thermiques. Ce réseau est couplé au système de plaque froide permettant le refroidissement du reste de la carte électronique. Pour optimiser au maximum le refroidissement du processeur, le liquide caloporteur doit être amené au plus proche de la source de chaleur. A cette fin, la demanderesse a mis spécifiquement au point un dissipateur thermique monophasique comportant un bloc de refroidissement en matériau thermoconducteur pouvant être alimenté en fluide caloporteur. La source de chaleur que constitue le processeur sera donc directement interfacée avec ce bloc de refroidissement (également désigné dans les exemples par le terme en anglais « waterblock ») alimenté en fluide caloporteur prélevé de la plaque froide. Un tel système de refroidissement intégré répond aux contraintes d'efficacité thermique, de compacité mécanique et de maintenabilité nécessaire pour ce type de matériel informatique haute performance. Cette solution est décrite en détail dans le document WO2019115963.

Classiquement, les éléments de refroidissement liquide de petite taille (waterblock) sont réalisés à partir d'un procédé de brasage sous vide ou continu. Cette technologie permet de solidariser les différentes pièces de la solution de refroidissement de manière permanente et d'assurer une étanchéité entre la cavité hydraulique interne et l'extérieur. L'un des avantages de cette solution est de pouvoir solidariser des pièces de géométrie complexe et de taille réduite. Pour solidariser les pièces, le brasage nécessite d'appliquer sur les pièces au préalable un flux de brasage, qui est une composition chimique constituant une primaire d'accrochage, afin de nettoyer et préparer les surfaces de contact. Une pâte à braser est ensuite appliquée comme élément de jonction entre les pièces, cette pâte étant composée de métal à point de fusion bas opérant corne une colle.

Cette solution présente toutefois plusieurs inconvénients. Tout d'abord, l'emploi de flux de brasage est un facteur de dégradation des propriétés anticorrosion des liquides de systèmes de refroidissement, générant une pollution qui obstrue les zones d'échange thermique et dégrade les performances du système de refroidissement. En outre, la pâte à braser peut migrer dans la cavité du système de refroidissement, et notamment obstruer les ailettes de la zone d'échange thermique, impactant également les performances thermiques du système. De plus, le brasage continu peut impliquer des pièces en aluminium dans un alliage moins performant thermiquement, i.e. possédant une conductivité moindre, et moins résistant dans le temps, notamment dans les séries 3003 d'aluminium. Les solutions antérieures ne sont pas optimisées pour un réseau hydraulique de supercalculateur dans le cadre de brasage d'aluminium et ne respectent pas les critères de durée de vie, d'homogénéité de matériaux et de performance thermique requis.

D'autres solutions de procédé de fabrication d'un dissipateur thermique sont connues par exemple de US2018/320993A1 et US2021/176896A1.

Il existe donc un besoin d'une solution simple et efficace permettant de remédier au moins en partie à ces inconvénients.

### [Exposé de l'invention]

A cette fin, l'invention a pour objet un procédé de fabrication d'un dissipateur thermique pour système de refroidissement liquide, notamment de lame de calcul de supercalculateur, ledit dissipateur thermique comprenant un corps, un organe de connexion fluidique et un module d'ailettes de dissipation thermique, ledit corps comprenant une face de collecte de chaleur, destinée à être positionnée au droit d'un composant électronique générant de la chaleur, une face de connexon fluidique, opposée à ladite face de collecte de chaleur, le corps délimitant une ouverture traversante centrale reliant la face de collecte de chaleur et la face de connexion fluidique, ledit organe de connexion fluidique comprenant une pièce centrale de forme parallélépipédique de laquelle s'étend, d'une première face, un élément de fixation et, d'une deuxième face, deux conduits de circulation d'un liquide réfrigérant, ledit module d'ailettes de dissipation thermique comprenant une plaque d'embase et au moins deux ensembles d'ailettes s'étendant depuis une face de ladite plaque d'embase, ledit procédé comprenant les étapes de :
- positionnement de l'élément de fixation de l'organe de connexion fluidique dans l'ouverture traversante du corps de sorte à venir à fleur de la face de collecte de chaleur du corps,
- usinage de la face de collecte de chaleur de sorte à former deux cavités de réception des ensembles d'ailettes du module d'ailettes, une nervure centrale, constituée à la fois de matière de l'élément de fixation de l'organe de connexion fluidique et de matière de la face de collecte de chaleur du corps, et un rebord de support de la plaque d'embase du module d'ailettes,
- placement du module d'ailettes sur le corps en appui sur le rebord de sorte que chaque ensemble d'ailettes soit disposé (i.e. placé) dans l'une des cavités,
- soudure par friction-malaxage de la plaque d'embase au niveau de la nervure centrale usinée et au niveau du rebord usiné.

La réalisation d'une nervure centrale et d'un rebord permettent le passage de la tête de l'outil de soudage par friction-malaxage. Notamment, l'assemblage de pièces par friction-malaxage permet de fabriquer un dissipateur thermique résistant à la pression du réseau hydraulique de liquide réfrigérant. La nervure centrale constitue un raidisseur permettant de solidariser toutes les pièces entre elles, notamment au niveau du raidisseur, afin de garantir la tenue sous pression tout en rendant le dissipateur thermique solide. Le procédé selon l'invention permet notamment d'obtenir un dissipateur thermique présentant des performances mécaniques, hydrauliques et thermiques répétables et à faible coût. Le soudage par friction-malaxage permet notamment l'utilisation de matériau particulièrement conducteur thermiquement. Le procédé selon l'invention évite l'utilisation de matériau d'apport (flux, pâte a braser), permettant de limiter les dégradations des propriétés du fluide utilisé. Le dissipateur thermique obtenu avec le procédé selon l'invention permet en outre de respecter l'encombrement alloué dans l'environnement mécanique des lames de calcul. En particulier, le procédé selon l'invention permet l'assemblage permanent d'un dissipateur thermique à refroidissement liquide, de petite taille et a géométrie complexe, sans différence de coût par rapport aux solutions antérieures.

Selon un aspect de l'invention, la plaque d'embase est soudée sur plus de la moitié de la longueur de la nervure centrale afin d'améliorer la solidité de la liaison entre la nervure centrale et la plaque d'embase du module d'ailettes.

De préférence, la plaque d'embase est soudée sur plus des trois-quarts de la longueur de la nervure centrale, par exemple sur toute la longueur de la nervure centrale, afin d'améliorer davantage la solidité de la liaison entre la nervure centrale et la plaque d'embase du module d'ailettes.

De préférence encore, la plaque d'embase est soudée sur le rebord sur toute sa périphérie afin d'améliorer la solidité de la liaison entre le corps et la plaque d'embase du module d'ailettes.

Selon un aspect de l'invention, le procédé comprend une étape préliminaire de fabrication du corps, de l'organe de connexion fluidique et du module d'ailettes, par exemple par usinage.

Avantageusement, le corps, l'organe de connexion fluidique et le module d'ailettes sont réalisés dans le même matériau, de préférence en métal. L'utilisation d'un même matériau permet de limiter le phénomène de corrosion galvanique.

Avantageusement encore, le corps, l'organe de connexion fluidique et le module d'ailettes sont réalisés en aluminium.

De préférence, le corps, l'organe de connexion fluidique et le module d'ailettes sont réalisés en aluminium série 6063, qui permet d'assurer les performances de refroidissement nécessaires pour l'application visée. L'aluminium série 6063 est en outre un matériau particulièrement durable dans le temps.

Selon un aspect de l'invention, la nervure centrale présente une surface de contact plane avec la plaque d'embase du module d'ailettes pour améliorer la qualité de la soudure entre la nervure centrale et la plaque d'embase du module d'ailettes.

De manière avantageuse, la largeur de la nervure centrale est comprise entre 3,9 et 6 mm. Cela permet au raidisseur d'être suffisamment large pour permettre le soudage par friction-malaxage tout en étant suffisamment étroit pour maximiser le nombre d'ailettes et améliorer ainsi la performance thermique du dissipateur.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation du dissipateur thermique selon l'invention, le corps étant montré en transparence.
[Fig 2] La figure 2 est une vue éclatée du dissipateur thermique de la figure 1 montrant le corps, l'organe de connexion fluidique et le module d'ailettes.
[Fig 3] La figure 3 illustre schématiquement l'assemblage de l'organe de connexion fluidique sur le corps.
[Fig 4] La figure 4 illustre schématiquement l'organe de connexion fluidique assemblé sur le corps.
[Fig 5] La figure 5 illustre schématiquement la face de collecte de chaleur du corps dans laquelle ont été usinées les cavités et la nervure centrale.
[Fig 6] La figure 6 illustre schématiquement l'assemblage du module d'ailettes sur le corps.
[Fig 7] La figure 7 illustre schématiquement le module d'ailettes assemblé sur le corps.
[Fig 8] La figure 8 illustre schématiquement le soudage du module d'ailettes sur le corps par friction-malaxage.
[Fig 9] La figure 9 est une vue en coupe du dissipateur thermique assemblé et soudé.
[Fig 10] La figure 10 illustre schématiquement un mode de réalisation du procédé de fabrication selon l'invention.

### [Description des modes de réalisation]

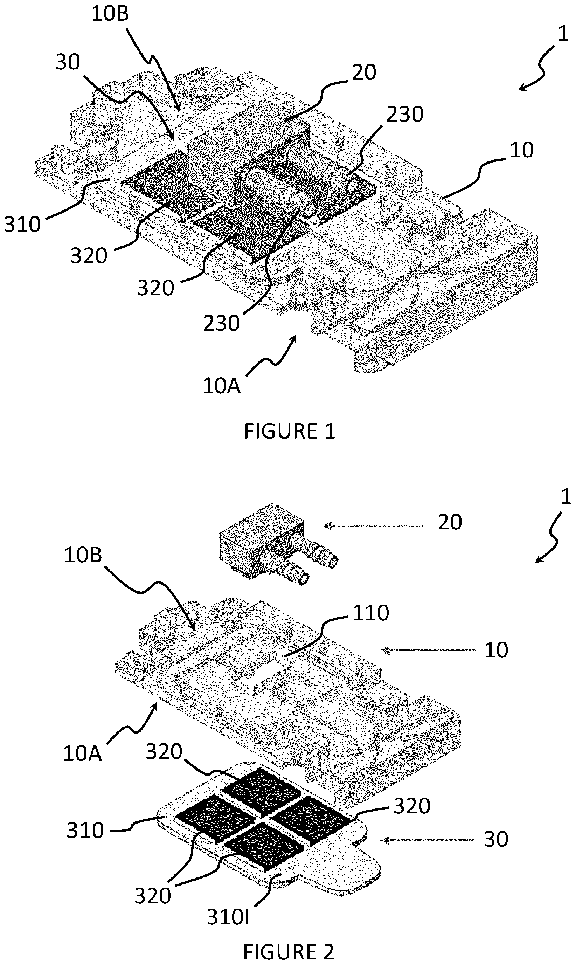

La figure 1 illustre un exemple de dissipateur thermique 1 selon l'invention. Le dissipateur thermique 1 est destiné à être monté dans un système de refroidissement liquide de supercalculateur.

### Dissipateur thermique 1

En référence aux figures 1 et 2, le dissipateur thermique 1 comprend un corps 10, un organe de connexion fluidique 20 et un module d'ailettes 30 de dissipation thermique.

### Corps 10

Le corps 10 comprend une face de collecte de chaleur 10A, destinée à être positionnée au droit d'un composant électronique générant de la chaleur (non représenté) afin de collecter ladite chaleur.

Le corps 10 comprend également une face de connexon fluidique 10B, opposée à la face de collecte de chaleur 10A.

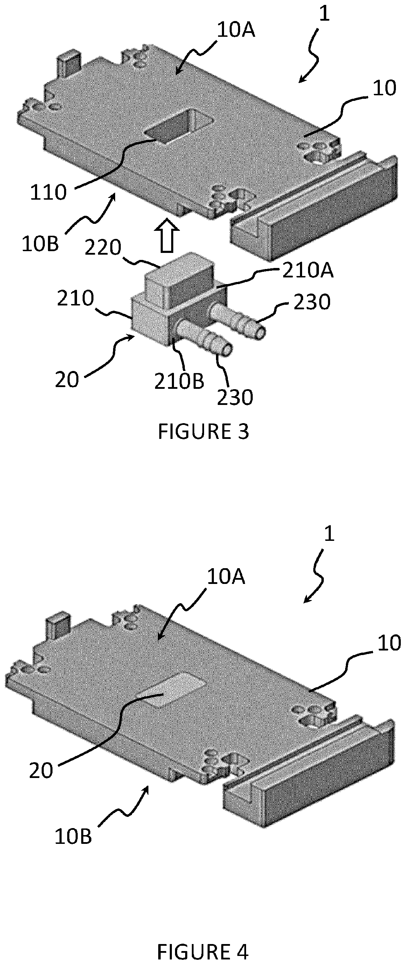

Le corps 10 délimite une ouverture traversante centrale 110, visible notamment sur les figures 2 et 3, reliant la face de collecte de chaleur 10A et la face de connexion fluidique 10B.

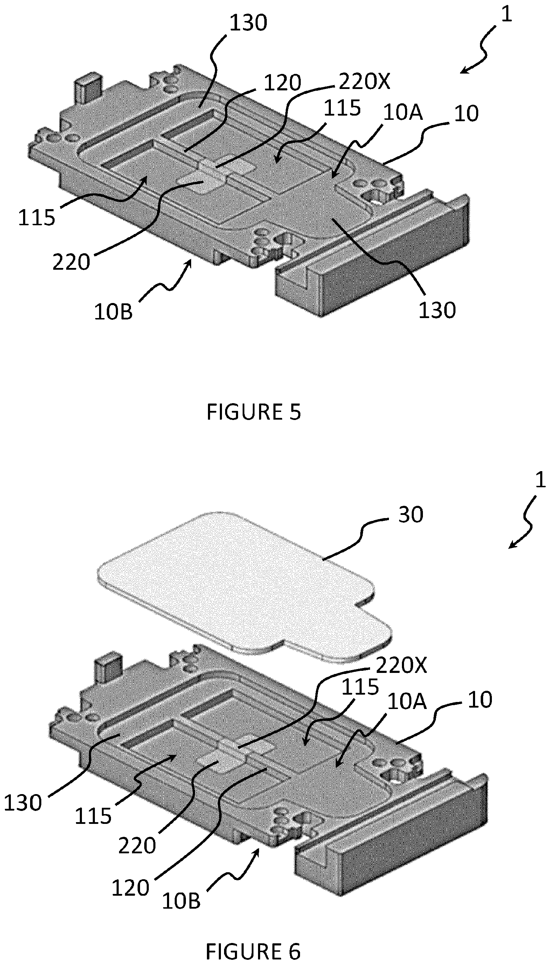

Comme illustré sur les figures 5 et 6, deux cavités 115 rectangulaires et un rebord 130 périphérique sont formés dans la face de collecte de chaleur 10A, les deux cavités 115 étant séparée par une nervure centrale 120.

### Organe de connexion fluidique 20

En référence à la figure 3, l'organe de connexion fluidique 20 comprend une pièce centrale 210, un élément de fixation 220 et deux conduits 230 de circulation d'un liquide réfrigérant.

Toujours en référence à la figure 3, la pièce centrale 210 est de forme parallélépipédique et comprend une première face 210A de laquelle s'étend l'élément de fixation 220 et une deuxième face 210B de laquelle s'étendent les deux conduits 230.

L'un des conduits 230 permet de recevoir du liquide réfrigérant pour capter les calories fournies par le module d'ailettes 30 tandis que l'autre conduit 230 permet d'évacuer le flux de liquide réfrigérant ainsi réchauffé pour l'acheminer hors du dissipateur thermique 1.

Dans l'exemple des figures, chaque conduit 230 comporte une tétine permettant de connecter et maintenir un tube (non représenté), de préférence flexible, par exemple réalisé en un matériau plastique, pour faire circuler le fluide réfrigérant.

Dans l'exemple des figures, la première face 210A et la deuxième face 210B ne sont pas des faces opposées de la pièce centrale 210, mais pourrait l'être dans une autre forme de réalisation.

L'élément de fixation 220 se présente dans cet exemple lui aussi sous la forme d'une pièce de forme parallélépipédique et de dimensions légèrement inférieures aux dimensions de la pièce centrale 210.

L'élément de fixation 220 est conformé pour s'emboîter à force, c'est-à-dire par friction et blocage, dans l'ouverture traversante 110 afin de maintenir l'organe de connexion fluidique 20 sur le corps 10.

En référence aux figures 5 et 6, l'élément de fixation 220 comporte, au niveau de la partie située du côté de la face de collecte 10A du corps 10, une portion 220X formant la nervure centrale 120 délimitée par les deux cavités 115 de la face de collecte de chaleur 10A du corps 10.

### Module d'ailettes 30

En référence à la figure 2, le module d'ailettes 30 comprend une plaque d'embase 310 et quatre ensembles d'ailettes 320 de dissipation thermique. Dans une autre forme de réalisation, le module d'ailettes 30 pourrait comprendre plus ou moins de quatre ensembles d'ailettes, de préférence un nombre pair.

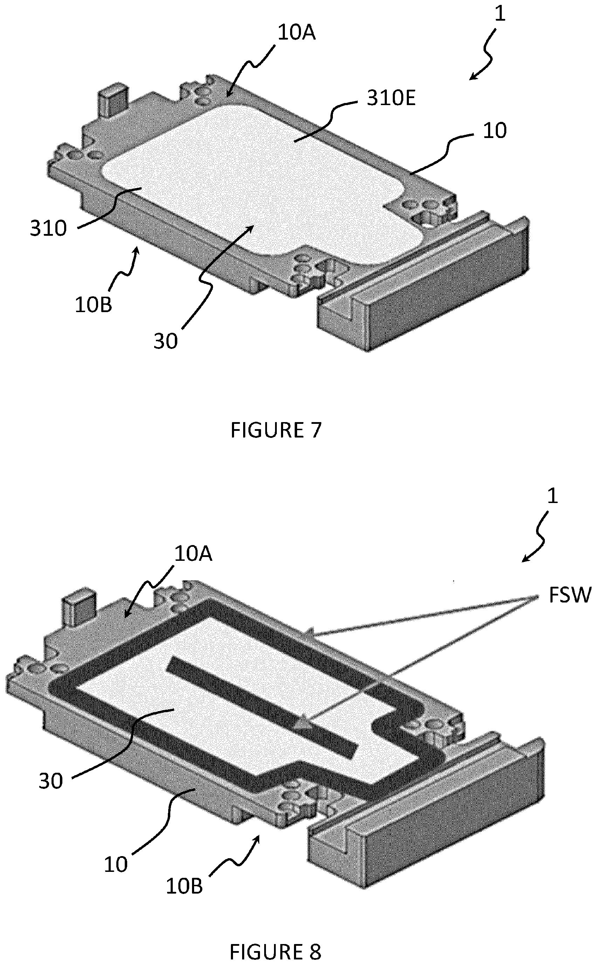

La plaque d'embase 310 est de forme rectangulaire et comporte une face externe 310E (figure 7) et une face interne 310I (figure 2). La face externe 310E est destinée à venir en regard du ou des composants électroniques à refroidir pour collecter leur chaleur.

Les deux ensembles d'ailettes 320 s'étendent depuis la face interne 310I en étant chacun positionné dans l'une des cavités 115 formées dans la face de collecte de chaleur 10A du corps 10.

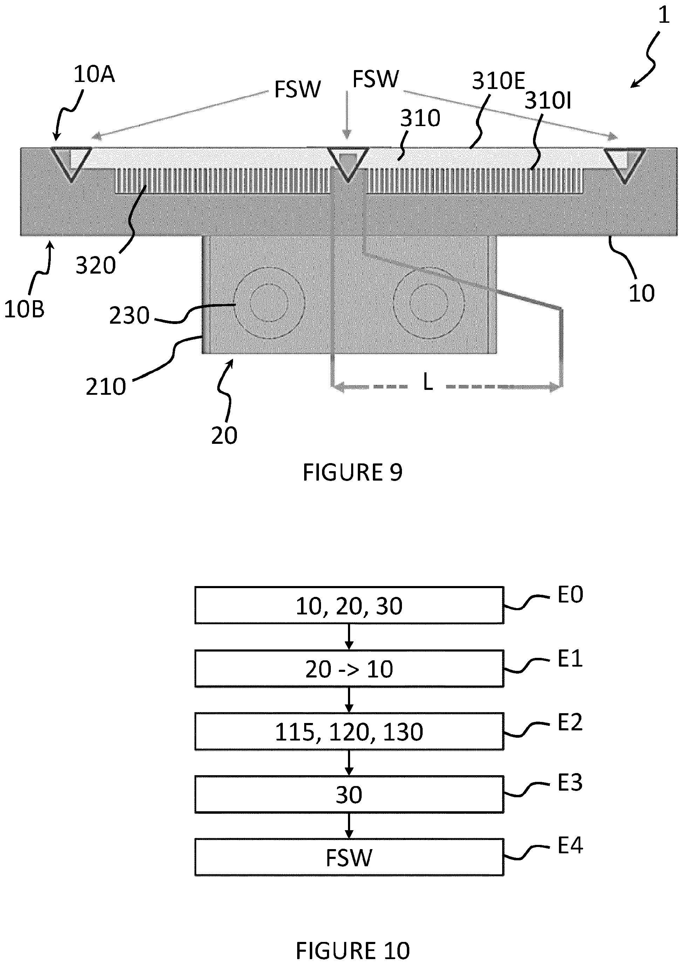

Comme illustré sur la figure 9, les ailettes des ensembles d'ailettes 320 s'étendent perpendiculairement de la face interne 3101 de la plaque d'embase 310 et permettent de collecter la chaleur reçue du ou des composants électroniques à refroidir à travers la plaque d'embase 310 pour la transférer au circuit de fluide réfrigérant circulant entre les deux conduits 230.

### Exemple de fabrication

Tout d'abord, dans une étape préliminaire E0, le corps 10, l'organe de connexion fluidique 20 et le module d'ailettes 30 sont fabriqués séparément, de préférence par usinage en aluminium série 6063.

Ensuite, afin de fabriquer le dissipateur thermique 1 selon l'invention, le procédé comprend une étape E1 de positionnement de l'élément de fixation 220 de l'organe de connexion fluidique 20 dans l'ouverture traversante 110 du corps 10 par emmanchement à force de sorte à venir à fleur de la face de collecte de chaleur 10A du corps 10, comme illustré sur la figure 4. A ce stade, la nervure centrale 120 n'est pas encore formée.

Ensuite, une étape E2 d'usinage de la face de collecte de chaleur 10A du corps 10 permet de former les deux cavités 115, la nervure centrale 120, constituée à la fois de matière de l'élément de fixation 220 de l'organe de connexion fluidique 20 et de matière de la face de collecte de chaleur 10A du corps 10, et un rebord 130 de support de la plaque d'embase 310 du module d'ailettes 30.

Dans une étape E3, le module d'ailettes 30 est positionné sur le corps 10 de sorte que chaque ensemble d'ailettes 320 soit placé dans l'une des cavités 115.

Enfin, une étape E4 de soudure par friction et malaxage permet de souder la plaque d'embase 310 à la fois au niveau de la nervure centrale 120 usinée et au niveau du rebord 130 usiné, de préférence sur l'ensemble son périmètre. La zone de soudure FSW est illustrée notamment sur les figures 8 et 9.

En référence à la figure 9, la largeur L de la nervure centrale 120 est choisie de préférence pour être suffisamment large pour permettre un soudage par friction-malaxage de qualité tout en étant suffisamment étroite pour maximiser le nombre d'ailettes qui peuvent être reçues dans les cavités 115. Ainsi, de préférence, la largeur de la nervure centrale 120 est comprise entre 3,9 et 6 mm.

L'invention présente ainsi de nombreux avantages, notamment d'éviter l'utilisation de produits de brasage tout en conférant une solidité au dissipateur à faible coût.

## Revendications

1. Procédé de fabrication d'un dissipateur thermique (1) pour système de refroidissement liquide d'une lame de calcul d'un supercalculateur, ledit dissipateur thermique (1) comprenant un corps (10), un organe de connexion fluidique (20) et un module d'ailettes (30) de dissipation thermique, ledit corps (10) comprenant une face de collecte de chaleur (10A), destinée à être positionnée au droit d'un composant électronique générant de la chaleur, et une face de connexon fluidique (10B), opposée à ladite face de collecte de chaleur (10A), le corps (10) délimitant une ouverture traversante (110) centrale reliant la face de collecte de chaleur (10A) et la face de connexion fluidique (10B), ledit organe de connexion fluidique (20) comprenant une pièce centrale (210) de forme parallélépipédique de laquelle s'étend, d'une première face (210A), un élément de fixation (220) et, d'une deuxième face (210B), deux conduits (230) de circulation d'un liquide réfrigérant, ledit module d'ailettes (30) comprenant une plaque d'embase (310) et au moins deux ensembles d'ailettes (320) s'étendant depuis une face (3101) de ladite plaque d'embase (310), ledit procédé comprenant les étapes de :
- positionnement (E1) de l'élément de fixation (220) de l'organe de connexion fluidique (20) dans l'ouverture traversante (110) du corps (10) de sorte à venir à fleur de la face de collecte de chaleur (10A) du corps (10),
- usinage (E2) de la face de collecte de chaleur (10A) de sorte à former deux cavités (115) de réception des ensembles d'ailettes (320) du module d'ailettes (30), une nervure centrale (120), constituée à la fois de matière de l'élément de fixation (220) de l'organe de connexion fluidique (20) et de matière de la face de collecte de chaleur (10A) du corps (10), et un rebord (130) de support de la plaque d'embase (310) du module d'ailettes (30),
- placement (E3) du module d'ailettes (30) sur le corps (10) en appui sur le rebord (130) de sorte que chaque ensemble d'ailettes (320) soit disposé dans l'une des cavités (115),
- soudure (E4) par friction-malaxage de la plaque d'embase (310) au niveau de la nervure centrale (120) usinée et au niveau du rebord (130) usiné.

2. Procédé selon la revendication 1, dans lequel la plaque d'embase (310) est soudée sur plus de la moitié de la longueur de la nervure centrale (120).

3. Procédé selon la revendication précédente, dans lequel la plaque d'embase (310) est soudée sur plus des trois-quarts de la longueur de la nervure centrale (120).

4. Procédé selon l'une quelconque des revendications précédentes, dans lequel la plaque d'embase (310) est soudée sur le rebord (130) sur toute sa périphérie.

5. Procédé selon l'une quelconque des revendications précédentes, comprenant une étape préliminaire (E0) de fabrication du corps (10), de l'organe de connexion fluidique (20) et du module d'ailettes (30), de préférence par usinage.

6. Procédé selon l'une quelconque des revendications précédentes, dans lequel le corps (10), l'organe de connexion fluidique (20) et le module d'ailettes (30) sont réalisés dans le même matériau, de préférence en métal.

7. Procédé selon la revendication précédente, dans lequel le corps (10), l'organe de connexion fluidique (20) et le module d'ailettes (30) sont réalisés en aluminium.

8. Procédé selon la revendication précédente, dans lequel le corps (10), l'organe de connexion fluidique (20) et le module d'ailettes (30) sont réalisés en aluminium série 6063.

9. Procédé selon l'une quelconque des revendications précédentes, dans lequel la nervure centrale (120) présente une surface de contact plane avec la plaque d'embase (310) du module d'ailettes (30).

10. Procédé selon l'une quelconque des revendications précédentes, dans lequel la largeur de la nervure centrale (120) est comprise entre 3,9 et 6 mm.

## Patentansprüche

1. Verfahren zum Herstellen einer Wärmesenke (1) für ein Flüssigkeitskühlsystem eines Computer-Blades eines Supercomputers, die Wärmesenke (1) umfassend einen Körper (10), ein Fluidverbindungsglied (20) und ein Wärmeableitungsrippenmodul (30), der Körper (10) umfassend eine Hitzesammelfläche (10A), die dazu bestimmt ist, in einer Linie mit einer elektronischen Komponente positioniert zu werden, die die Hitze erzeugt, und eine Fluidverbindungsfläche (10B) gegenüber der Hitzesammelfläche (10A), wobei der Körper (10) eine zentrale Durchgangsöffnung (110) begrenzt, die die Hitzesammelfläche (10A) und die Fluidverbindungsfläche (10B) verbindet, das Fluidverbindungsglied (20) umfassend ein zentrales Stück (210) mit Parallelepipedform, von dem sich von einer ersten Fläche (210A) ein Befestigungselement (220) und von einer zweiten Fläche (210B) zwei Leitungen (230) zum Zirkulieren eines flüssigen Kältemittels erstreckt, das Rippenmodul (30) umfassend eine Grundplatte (310) und mindestens zwei Rippensätze (320), die sich von einer Fläche (310I) der Grundplatte (310) erstrecken, das Verfahren umfassend die Schritte:
- Positionieren (E1) des Befestigungselements (220) des Fluidverbindungsglieds (20) in der Durchgangsöffnung (110) des Körpers (10), sodass es mit der Hitzesammelfläche (10A) des Körpers (10) bündig ist,
- Bearbeiten (E2) der Hitzesammelfläche (10A), um zwei Hohlräume (115) zum Aufnehmen der Rippensätze (320) des Rippenmoduls (30), einen zentralen Wulst (120), der zugleich aus dem Material des Befestigungselements (220) des Fluidverbindungsglieds (20) und dem Material der Hitzesammelfläche (10A) des Körpers (10) besteht, und einen Rand (130) zum Tragen der Grundplatte (310) des Rippenmoduls (30) auszubilden,
- Platzieren (E3) des Rippenmoduls (30) auf dem Körper (10) anliegend an den Rand (130), so dass jeder Rippensatz (320) in einem der Hohlräume (115) angeordnet ist,
- Schweißen (E4) durch Rührreiben der Grundplatte (310) an dem bearbeiteten zentralen Wulst (120) und an dem bearbeiteten Rand (130).

2. Verfahren nach Anspruch 1, wobei die Grundplatte (310) über mehr als die Hälfte der Länge des zentralen Wulsts (120) verschweißt wird.

3. Verfahren nach dem vorstehenden Anspruch, wobei die Grundplatte (310) über mehr als drei Viertel der Länge des zentralen Wulsts (120) verschweißt wird.

4. Verfahren nach einem der vorstehenden Ansprüche, wobei die Grundplatte (310) über ihren gesamten Umfang mit dem Rand (130) verschweißt wird.

5. Verfahren nach einem der vorstehenden Ansprüche, umfassend einen vorbereitenden Schritt (E0) des Herstellens des Körpers (10), des Fluidverbindungsglieds (20) und des Rippenmoduls (30), vorzugsweise durch Bearbeiten.

6. Verfahren nach einem der vorstehenden Ansprüche, wobei der Körper (10), das Fluidverbindungsglied (20) und das Rippenmodul (30) aus demselben Material, vorzugsweise aus Metall, gebildet sind.

7. Verfahren nach dem vorstehenden Anspruch, wobei der Körper (10), das Fluidverbindungsglied (20) und das Rippenmodul (30) aus Aluminium gebildet sind.

8. Verfahren nach dem vorstehenden Anspruch, wobei der Körper (10), das Fluidverbindungsglied (20) und das Rippenmodul (30) aus Aluminium von Serie 6063 gebildet sind.

9. Verfahren nach einem der vorstehenden Ansprüche, wobei der zentrale Wulst (120) eine ebene Kontaktoberfläche mit der Grundplatte (310) des Rippenmoduls (30) aufweist.

10. Verfahren nach einem der vorstehenden Ansprüche, wobei die Breite des zentralen Wulsts (120) zwischen 3,9 und 6 mm beträgt.

## Claims

1. A method for producing a heat sink (1) for a liquid cooling system of a supercomputer computing blade, said heat sink (1) comprising a body (10), a fluidic connection member (20) and a heat dissipation fin module (30), said body (10) comprising a heat collection face (10A) intended to be positioned in line with a heat-generating electronic component, and a fluidic connection face (10B) opposite said heat collection face (10A), the body (10) delimiting a central through-opening (110) connecting the heat collection face (10A) and the fluidic connection face (10B), said fluidic connection member (20) comprising a parallelepiped central part (210) from which extends, from a first face (210A), an attachment element (220) and, from a second face (210B), two channels (230) for circulating a liquid coolant, said fin module (30) comprising a base plate (310) and at least two fin assemblies (320) extending from one face (310I) of said base plate (310), said method comprising the steps of:
- positioning (E1) the attachment element (220) of the fluidic connection member (20) in the through-opening (110) of the body (10) so as to be flush with the heat collection face (10A) of the body (10),
- machining (E2) the heat collection face (10A) so as to form two cavities (115) for receiving the fin assemblies (320) of the fin module (30), a central rib (120) consisting of both the material of the attachment element (220) of the fluidic connection member (20) and the material of the heat collection face (10A) of the body (10), and a rim (130) for supporting the base plate (310) of the fin module (30),
- placing (E3) the fin module (30) on the body (10) so as to bear on the rim (130) such that each fin assembly (320) is arranged in one of the cavities (115),
- friction stir welding (E4) the base plate (310) at the machined central rib (120) and at the machined rim (130).

2. The method according to claim 1, wherein the base plate (310) is welded over more than half the length of the central rib (120).

3. The method according to the preceding claim, wherein the base plate (310) is welded over more than three-quarters of the length of the central rib (120).

4. The method according to any of the preceding claims, wherein the base plate (310) is welded onto the rim (130) over its entire periphery.

5. The method according to any of the preceding claims, comprising a preliminary step (E0) of producing the body (10), the fluidic connection member (20) and the fin module (30), preferably by machining.

6. The method according to any of the preceding claims, wherein the body (10), the fluidic connection member (20) and the fin module (30) are made of the same material, preferably metal.

7. The method according to the preceding claim, wherein the body (10), the fluidic connection member (20) and the fin module (30) are made of aluminium.

8. The method according to the preceding claim, wherein the body (10), the fluidic connection member (20) and the fin module (30) are made of aluminium 6063.

9. The method according to any of the preceding claims, wherein the central rib (120) has a planar contact surface with the base plate (310) of the fin module (30).

10. The method according to any of the preceding claims, wherein the width of the central rib (120) is between 3.9 and 6 mm.
